(19)

Europäisches Patentamt

European Patent Office

Office européen des brevets

(11) **EP 1 296 455 A1**

(12) **EUROPEAN PATENT APPLICATION**

(43) Date of publication:
**26.03.2003 Bulletin 2003/13**

(51) Int Cl.[7]: **H03H 17/02**, H03H 17/04

(21) Application number: **01122978.8**

(22) Date of filing: **25.09.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Sony International (Europe) GmbH**
**10785 Berlin (DE)**

(72) Inventors:
• **Nöthlings, Rolf,**
**Advanced Technology Ct. Stuttgart**
**70327 Stuttgart (DE)**

• **Wildhagen, Jens,**
**Advanced Technology Ct. Stuttgart**
**70327 Stuttgart (DE)**

(74) Representative: **Müller - Hoffmann & Partner**
**Patentanwälte,**
**Innere Wiener Strasse 17**
**81667 München (DE)**

(54) **Memory-efficient realization of a digital filter**

(57)     A digital filter of order 2N receiving a M-times multiplexed input signal (x) with a sampling rate ($f_S$) and outputting a M-times multiplexed output signal (y) with said sampling rate ($f_S$), wherein a modified filter of order 1 in which 2N filter coefficients ($a_{n,1}, a_{n,0}, 1 \leq n \leq N$) get periodidically switched with a clock frequency ($f_c$) that equals to $M \cdot 2N$-times said sampling rate ($f_S$) to set the filter periodically into $M \cdot 2N$ internal filter states in each of which an internal output value is calculated before one complete sample of the M-times multiplexed output signal (y) is output, is characterized in that the 2N filter coefficients are determined so that N component filters of order 2 are build as a serial concatenation and the delayed output samples of everyone of the component filters are used as delayed input samples of the following component filter.

**Figure 1**

EP 1 296 455 A1

## Description

This invention relates to the realization of a digital filter, in particular to the realization of a digital filter of order 2N that can be used to filter real, complex or M-times multiplexed signals which is realized as a modified allpass filter of order 1 and operates with a 2N·M times higher sampling rate while periodically changing 2N filter coefficients.

Such a digital filter of order 2N that receives a M-times multiplexed input signal with a sampling rate fs and outputs a M-times multiplexed output signal with said sampling rate fs that comprises a modified allpass filter of order 1 in which 2N filter coefficients get periodically switched with a clock frequency $f_c$ that equals to M·2N-times said sampling rate fs to set the filter periodically into M·2N internal filter states in each of which an internal output value is calculated before outputting one complete sample of the M-times multiplexed output signal is described in the european patent application EP 98 114 111.2 of the applicant which content is herewith incorporated into this specification. The shown filter is usable as highpass, lowpass or allpass filter in which case an additional adder would be necessary.

In digital receivers such IIR filters are often used, since they have big advantages in memory and calculation power costs compared to a FIR filter with a comparable transfer function. Especially when these filters have to be realized on an ASIC they should be as small as possible to reduce costs. That means that such a filter should be realized with as few elemets as possible.

Therefore, it is the object underlying the present invention to provide a digital filter of order 2N that needs less elements than state of the art filters.

This object is solved by a digital filter according to independent claim 1. Preferred embodiments thereof are defined in dependent claims 2 and 3. Further, the object is solved by a method to use a digital filter as defined in independent claim 4. A preferred embodiment thereof is defined in dependent claim 5. Furthermore, a computer program product embodying the present invention and its preferred embodiments is defined in claim 6.

Therefore, in a digital filter of order 2N receiving a M-times multiplexed input signal with a sampling rate $f_s$ and outputting a M-times multiplexed output signal with said sampling rate, wherein a modified filter of order 1 in which 2N filter coefficients get periodidically switched with a clock frequency that equals to M·2N-times said sampling rate to set the filter periodically into M·2N internal filter states in each of which an internal output value is calculated before one complete sample of the M-times multiplexed output signal is output, according to the present invention is characterized in that said 2N filter coefficients are determined so that N component filters of order 2 are build as a serial concatenation and the delayed output samples of everyone of the component filters are used as delayed input samples of the following component filter.

Similar as described in the above referenced EP 98 114 111.2 which content is incorporated into this specification, according to the present invention an IIR filter which needs only one multiplier is realized by operating on a higher clock rate. Moreover, according to the present invention additionally the memory requirements are minimized. This is obtained by transforming the filter transfer function into a product of 2nd order filters which are realized in a serial concatenation. So the output delay elements (memory) of one component filter are used as input delay elements for the next component filter as well.

Moreover, a 2nd order concatenation is more stable compared to the direct implementation.

Therefore, in the digtal filter according to the present invention preferrably each M·2N$^{th}$ internal output value represents one sample of the output signal.

The method to use a digital filter of order 2N receiving a M-times multiplexed input signal with a sampling rate and outputting a M-times multiplexed output signal with said sampling rate, wherein a modified filter of order 1 in which 2N filter coefficients get periodically switched with a clock frequency that equals to M·2N-times said sampling rate $f_s$ to set the filter periodically into M·2N internal filter states in each of which an internal output value is calculated before one complete sample of the M-times multiplexed output signal is output, according to the present invention is characterized by determining the 2N filter coefficients so that N component filters of order 2 are build as a serial concatenation and using the delayed output samples of everyone of the component filters as delayed input samples of the following component filter.

Further features and advantages of the digital filter or the method to use a digital filter according to the present invention will become apparent from the following description of an exemplary embodiment taken in conjunction with the accompanying figures, in which:

**Figure 1**   shows a block diagram of a digital allpass filter M·2N$^{th}$ order according to the present invention;

**Figure 2**   shows a block diagram of a digital allpass filter 6$^{th}$ order according to the present invention with no multiplex, i.e. with M=1 and N=3;

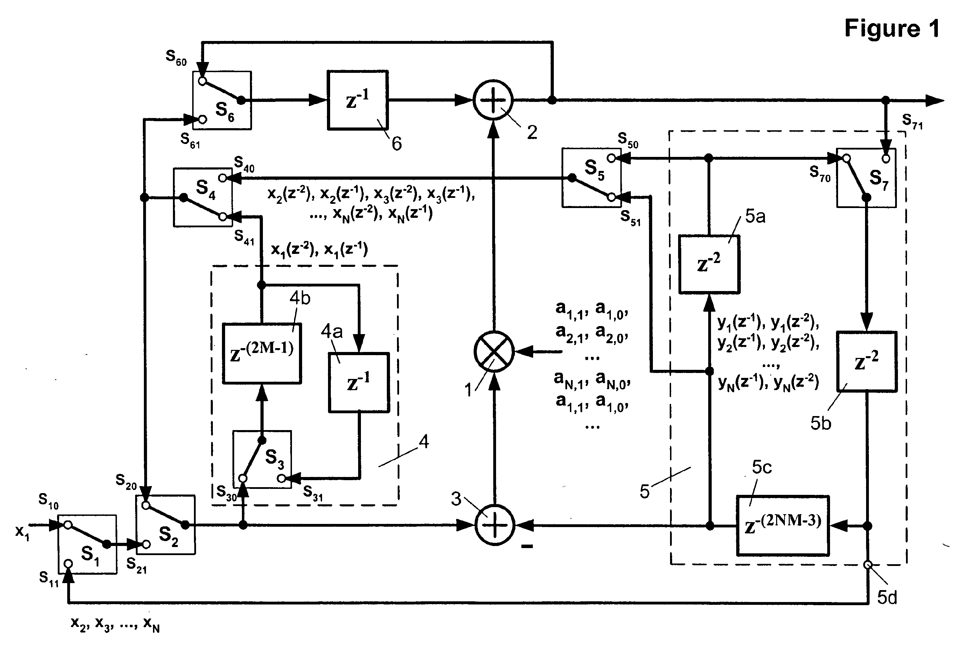

Figure 1 shows a digital filter IIR allpass filter that consists of only one multiplier 1 and an optimized memory usage. Similar as described in the above referenced EP 98 114 111.2 which content is incorporated into this specification, the reduction down to only one multiplier 1 is obtained by running the filter with a higher clock rate, i.e. 2N·$f_S$·M in case the input signal has a clock rate $f_S$ and a filter of order 2N with a M-times multiplexed signal is realized, and changing the coefficient at the multiplier 1 each clock cycle. The filter coefficients are provided at the multiplier in a special order.

The optimization of the needed memory is obtained by transforming the filter transfer function into a transfer function consisting of 2nd order filters, which then are realized in a serial concatenation. Therefore every IIR filter which has the transfer function (1) is transformed in a filter with a transfer function in the form (2).

$$H_{AP}(z) = \frac{\bar{a}_0 + \bar{a}_1 z^{-1} + \bar{a}_2 z^{-2} + ... + \bar{a}_{2N-1} z^{-(2N-1)} + z^{-2N}}{1 + \bar{a}_{2N-1} z^{-1} + ... + \bar{a}_1 z^{-(2N-1)} + \bar{a}_0 z^{-2N}} \tag{1}$$

$$H_{AP}(z) = \frac{a_{1,0} + a_{1,1} z^{-1} + z^{-2}}{1 + a_{1,1} z^{-1} + a_{1,0} z^{-2}} * \frac{a_{2,0} + a_{2,1} z^{-1} + z^{-2}}{1 + a_{2,1} z^{-1} + a_{2,0} z^{-2}} * ... * \frac{a_{N,0} + a_{N,1} z^{-1} + z^{-2}}{1 + a_{N,1} z^{-1} + a_{N,0} z^{-2}} \tag{2}$$

with

$$z = e^{j\Omega}$$

$$\Omega = \frac{2\pi f}{f_s}$$

$f_s$:        sampling rate.

Form (2) is a serial concatenation of 2nd order filters, wherein the output of the preceding filter is the input to the next one. Therefore, the delayed input samples of one of these 2nd order component filters are the delayed output samples of the preceding component filter so that they only needed to be stored once. Thus the delay elements containing these values can be shared and memory can be reduced. Of course, a special order of delay elements and of switches to provide the right values should be choosen.

A block diagramm of the exemplary embodiment of a digital filter according to the present invention is shown in figure 1. N is the number of 2nd order allpass filters and M is the number of multiplexed signals. As shown in figure 1, some switches are used to provide the right samples at the right time:

A first switch $S_1$ receives the input signal x, here an input sample $x_1$, at its first input terminal $S_{10}$ and provides the actual input samples to the respective serial filters. This means that the first switch $S_1$ has to provide $x_1$ for two cycles (since 2nd order component filters are used), in particular, $x_1$ is only needed at the second cycle, since the value for the first cycle can be internally provided, and then the inputs of the next component filters $x_2 ... x_n$, which are the outputs of the respective preceding component filters. Therefore, the first switch $S_1$ receives these outputs from a first output 5d of an output ring buffer 5 at its second input terminal $S_{11}$.

A second switch $S_2$ which receives the output of the first switch $S_1$ at its second input terminal $S_{21}$ provides the actual input sample for each filter step and its delayed elements. Therefore, the second switch $S_2$ receives these delayed elements at its first input terminal $S_{20}$. As all serial component filters are of second order, the second switch $S_2$ is alternating. The output of the second switch $S_2$ is provided as minuend to a subtracter 3 which supplies its calculated difference to the only multiplier 1 of the digital filter which - as stated above - additionally receives the changing filter coefficients. Additionally, the output of the second switch $S_2$ is provided to a hold unit 4.

In the above notation, the first multiplier gets the samples in an order: $a_{1,1}$, $a_{1,0}$, $a_{2,1}$, $a_{2,0}$, ..., $a_{N,1}$, $a_{N,0}$, $a_{1,1}$, $a_{1,0}$, ..., i.e. the filter coefficients are repeated after all 2N filter coefficients $a_{1,1}$, $a_{1,0}$, $a_{2,1}$, $a_{2,0}$, ..., $a_{N,1}$, $a_{N,0}$ have been supplied to the multiplier 1.

A third switch $S_3$ is part of the hold unit 4 which provides the delayed input elements of the first filter. These input elements are held while the other 2 ... N component filters are working. Therefore, the hold unit 4 comprises the third switch $S_3$ which receives the output of the second switch $S_2$ at its first input terminal $S_{30}$, a first delay element 4b having a delay (2M-1) receiving the output of the third switch $S_3$, and a second delay element 4a receiving the output of the first delay element 4b, providing a delay of 1, and supplying its one sample delayed output to the second input $S_{31}$ of the third switch $S_3$. The output of the hold unit 4 is the output signal of the first delay element 4b. The hold unit 4 can alternatively also be realized by a latch enable control.

As stated before, the first and second switches $S_1$ and $S_2$ provide the delayed input samples for the 2 ... N component filters which are the delayed output samples of the 1 ... N-1 component filters.

Therefore, to provide this functionality, a fourth switch $S_4$ which receives the output of the hold unit 4 at its

second input terminal $S_{41}$ and which output is connected to the first input $S_{20}$ of the second switch $S_2$ provides the samples $x_1(z^{-2})$, $x_1(z^{-1})$ in one position, here in the lower position $S_{41}$, and then the samples $x_2(z^{-2})$, $x_2(z^{-1})$, $x_3(z^{-2})$, $x_3$ $(z^{-1})$ ... $x_N(z^{-2})$, $x_N(z^{-1})$ in the other position, here in the upper position $S_{40}$. The fourth switch $S_4$ receives the delayed output samples of the filters 1 ... N-1 at its first input terminal $S_{40}$.

The delayed output samples of the 1 ... N-1 component filters have to be mixed up, since they have to be provided in the "right" way, but are stored in "wrong" way, i.e they appear in the opposite direction at the output output of the ring buffer 5. Therefore, an alternating fifth switch $S_5$ which output is connected to the first input terminal $S_{40}$ of the fourth switch $S_4$ is used to provide the sample $x_N(z^{-2})$ in one position, here the lower position $S_{51}$, and one clock cycle later the sample $x_N(z^{-1})$ in the other position, here in the upper position $S_{50}$. Therefore, the first input $S_{50}$ of the fifth switch $S_5$ receives the sample $x_N(z^{-1})$ from a third delay element 5a included in the output buffer 5 and the second input $S_{51}$ of the fifth switch $S_5$ receives the sample $x_N(z^{-2})$ from a fourth delay element 5c included in the output buffer 5. The third delay element 5a has a delay 2 and the fourth delay element 5c has a delay (2NM-3). The input of the third delay element 5a is connected to the output of the fourth delay element 5c. The output of the fourth delay element 5c is further supplied as subtra-hend to the subtracter 3. The output buffer 5 comprises further a fifth delay element 5b with delay 2 which output is connected to the input of the fourth delay element 5c and - via the first output 5d of the output buffer 5 - to the second input $S_{11}$ of the first switch $S_1$.

A sixth switch $S_6$ which receives the output of the fourth switch $S_4$ at its second input terminal $S_{61}$ and a following sixth delay element 6 with delay 1 determine the actual output sample, e. g. $y_1$, since the output of the sixth delay element 6 is supplied as first summand to an adder 2 which receives the output of the multiplier 1 as second summand and which supplies the output signal y of the digital filter. A valid output sample of one serial 2nd order component filter is determined after 2 clock cycles. One output of the completed filter is determined after 2N clock cycles. As only 2nd order component filters are used the sixth switch $S_6$ which receives the sum signal generated by the adder 2 at its first input $S_{60}$ is alternating.

A seventh switch $S_7$ comprised in the output ring buffer 5 loads alternating the actual output samples into the ring buffer 5 via its second input terminal $S_{71}$ to provide it as an input to the next 2nd order component filter and as a delayed output $y(z^{-1})$ for the 2nd order component filter itself and via its first input terminal $S_{70}$ the one step delayed outputs of the output ring buffer which are also supplied to the first input terminal $S_{50}$ of the fifth switch $S_5$ to provide it as the two steps delayed outputs $y(z^{-2})$ for the next component filter. Therefore, the output of the seventh switch $S_7$ is connected to the input of the fifth delay element 5b.

With selection of M the filter can also be multiplexed, used for IQ data or antenna diversity data etc.

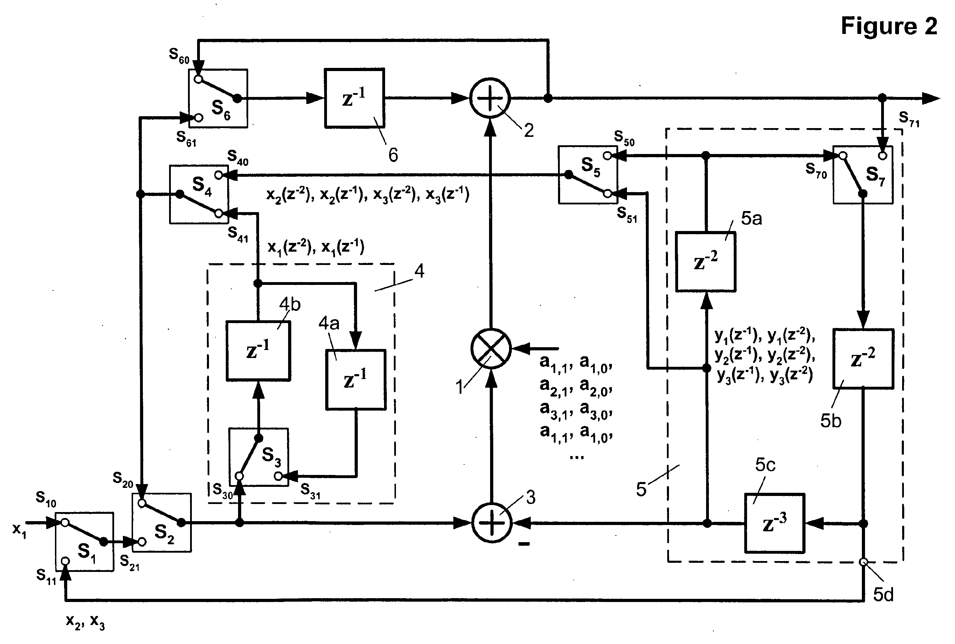

Figure 2 shows a block diagram of an embodiment of the digital filter shown in figure 1, wherein N = 2 and M = 1 is choosen.

The following table 1 shows the status of switches for said filter of 6th order, e. g. with N = 3 serial 2nd order component filters. Moreover table 2 shows the corresponding samples provided by the respective switches. The clock rate inside the filter is $6*f_s$, no multiplex (M = 1) is used.

Table 1:

| Position of each switch over clock cycle | | | | | | |
|---|---|---|---|---|---|---|
| | 1 | 2 | 3 | 4 | 5 | 6 |
| $S_1$ | $S_{10}$ | $S_{10}$ | $S_{11}$ | $S_{11}$ | $S_{11}$ | $S_{11}$ |
| $S_2$ | $S_{20}$ | $S_{21}$ | $S_{20}$ | $S_{21}$ | $S_{20}$ | $S_{21}$ |
| $S_3$ | $S_{30}$ | $S_{30}$ | $S_{31}$ | $S_{31}$ | $S_{31}$ | $S_{31}$ |
| $S_4$ | $S_{41}$ | $S_{40}$ | $S_{40}$ | $S_{40}$ | $S_{40}$ | $S_{41}$ |
| $S_5$ | $S_{51}$ | $S_{50}$ | $S_{51}$ | $S_{50}$ | $S_{51}$ | $S_{50}$ |
| $S_6$ | $S_{60}$ | $S_{61}$ | $S_{60}$ | $S_{61}$ | $S_{60}$ | $S_{61}$ |
| $S_7$ | $S_{70}$ | $S_{71}$ | $S_{70}$ | $S_{71}$ | $S_{70}$ | $S_{71}$ |

Table 2:

| Passed sample of each switch over clock cycle | | | | | | | |
|---|---|---|---|---|---|---|---|
| | | 1 | 2 | 3 | 4 | 5 | 6 |
| $S_1$ | | / | $x_1(n)$ | / | $x_2(n)$ | / | $x_3(n)$ |

Table 2: (continued)

| Passed sample of each switch over clock cycle | | | | | | |
|---|---|---|---|---|---|---|
| | **1** | **2** | **3** | **4** | **5** | **6** |
| $S_2$ | $x_1(n-1)$ | $x_1(n)$ | $x_2(n-1)$ | $x_2(n)$ | $x_3(n-1)$ | $x_3(n)$ |
| $S_3$ | $x_1(n-1)$ | $x_1(n)$ | $x_1(n-1)$ | $x_1(n)$ | $x_1(n-1)$ | $x_1(n)$ |
| $S_4$ | $x_1(n-1)$ | $x_2(n-2)$ | $x_2(n-1)$ | $x_3(n-2)$ | $x_3(n-1)$ | $x_1(n-2)$ |
| $S_5$ | / | $y_1(n-2)$ | $y_1(n-1)$ | $y_2(n-2)$ | $y_2(n-1)$ | / |
| $S_6$ | $a_{1,1}*x_1(n-1) + x_1(n-2)$ | $x_2(n-2)$ | $a_{2,1}*x_2(n-1) + x_2(n-2)$ | $x_3(n-2)$ | $a_{3,1}*x_3(n-1) + x_3(n-2)$ | $x_1(n-2)$ |
| $S_7$ | $y_3(n-1)$ | $y_1(n) = a_{1,0}*x_1(n) + a_{1,1}*x_1(n-1) +x_1(n-2)$ | $y_1(n-1)$ | $y_2(n) = a_{2,0}*x_2(n) + a_{2,1}*x_2(n-1) +x_2(n-2)$ | $y_2(n-1)$ | $y_3(n) = a_{3,0}*x_3(n) + a_{3,1}*x_3(n-1) +x_3(n-2)$ |
| Coefficient | $a_{1,1}$ | $a_{1,0}$ | $a_{2,1}$ | $a_{2,0}$ | $a_{3,1}$ | $a_{3,0}$ |

Therewith, according to the exemplary embodiments of present invention an allpass IIR filter is realized which is reduzed in size, e. g. a realization is achieved with as few elements (multiplier, delay elements (memory)) as possible. Such a realization on an ASIC is smaller, i. e. cheaper.

Only one multiplier is necessary because of running of the filter at a higher clock rate.

The improvement compared to the above referenced EP 98 114 111.2 which content is incorporated into this specification is the reduced memory requirement, achieved using a 2$^{nd}$ order form of the allpass filter. Here the same delay elements for the output of serial 2$^{nd}$ order component filter and the next 2$^{nd}$ order component filter can be shared. Moreover a 2$^{nd}$ order concatenation is more stable.

The filter can be multiplexed, and is most useful for allpass filters consisting of at least two 2$^{nd}$ order component filters. For a filter with one 2$^{nd}$ order filter no memory sharing is possible, therefore the first to fifth switches $S_1$, $S_2$, $S_3$, $S_4$ and $S_5$ have no functionality, and the third to fifth delay elements 5c, 5a, and 5b at the output ring buffer 5 have to have a different order. Such a filter is already disclosed in the above referenced EP 98 114 111.2.

Further, the filter is most effective for an allpass filter of equal order. Otherwise one coefficient gets set to zero.

Of course, a digital filter according to the present invention can also build a lowpass, a bandpass, or a highpass filter with slight additional modification(s), i.e. at least one additional adder would be necessary.

## Claims

1. Digital filter of order 2N receiving a M-times multiplexed input signal (x) with a sampling rate ($f_S$) and outputting a M-times multiplexed output signal (y) with said sampling rate ($f_S$), wherein a modified filter of order 1 in which 2N filter coefficients ($a_{n,1}$,$a_{n,0}$, $1 \leq n \leq N$) get periodidically switched with a clock frequency ($f_c$) that equals to M·2N-times said sampling rate (fs) to set the filter periodically into M·2N internal filter states in each of which an internal output value is calculated before one complete sample of the M-times multiplexed output signal (y) is output, **characterized in that** the 2N filter coefficients are determined so that N component filters of order 2 are build as a serial concatenation and the delayed output samples of everyone of the component filters are used as delayed input samples of the following component filter.

2. Filter according to claim 1, **characterized in that** each M·2N$^{th}$ internal output value represents one sample of the output signal (y).

3. Method to use a digital filter of order 2N receiving a M-times multiplexed input signal (x) with a sampling rate ($f_S$) and outputting a M-times multiplexed output signal (y) with said sampling rate ($f_S$), wherein a modified filter of order 1 in which 2N filter coefficients ($a_{n,1}$,$a_{n,0}$, $1 \leq n \leq N$) get periodidically switched with a clock frequency ($f_c$) that equals to M·2N-times said sampling rate ($f_S$) to set the filter periodically into M·2N internal filter states in each of which an internal output value is calculated before one complete sample of the M-times multiplexed output signal (y) is output, **characterized by** determining the 2N filter coefficients so that N component filters of order 2 are build as a serial concatenation and using the delayed output samples of everyone of the component filters as delayed input samples of the following component filter.

4. Computer program product, **characterized by** computer program means adapted to embody the digital filter as defined in anyone of claims 1 to 3 when said computer program product is executed on a computer, digital signal processor or the like.

Figure 1

EP 1 296 455 A1

**Figure 2**

**European Patent Office**

**EUROPEAN SEARCH REPORT**

Application Number

EP 01 12 2978

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | EP 0 977 359 A (SONY INT EUROP GMBH) 2 February 2000 (2000-02-02) * page 3, line 57 - page 7, line 37; figures * | 1-4 | H03H17/02 H03H17/04 |
| A | HATAMIAN M ET AL: "AN 85-MHZ FOURTH-ORDER PROGRAMMABLE IIR DIGITAL FILTER CHIP" IEEE JOURNAL OF SOLID-STATE CIRCUITS, IEEE INC. NEW YORK, US, vol. 27, no. 2, 1 February 1992 (1992-02-01), pages 175-183, XP000289375 ISSN: 0018-9200 * paragraphs [000I]-[0III]; figures * | 1-4 | |
| A | EP 1 079 523 A (FORD MOTOR CO) 28 February 2001 (2001-02-28) * paragraph [0018]; figure 4 * | 1-4 | |

TECHNICAL FIELDS SEARCHED (Int.Cl.7)

H03H

The present search report has been drawn up for all claims

| Place of search | Date of completion of the search | Examiner |
|---|---|---|
| THE HAGUE | 18 February 2002 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 01 12 2978

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2002

| Patent document cited in search report | | Publication date | Patent family member(s) | | Publication date |
|---|---|---|---|---|---|
| EP 0977359 | A | 02-02-2000 | EP | 0977359 A1 | 02-02-2000 |
| EP 1079523 | A | 28-02-2001 | EP | 1079523 A2 | 28-02-2001 |
| | | | JP | 2001119270 A | 27-04-2001 |

EPO FORM P0459